# EUROPÄISCHE PATENTSCHRIFT

(11) **EP 1 306 968 B1**
(45) Veröffentlichungstag und Bekanntmachung des Hinweises auf die Patenterteilung: **10.08.2011**
(21) Anmeldenummer: 02023527.1
(22) Anmeldetag: 22.10.2002
(51) Int. Cl.: H03B 11/02, F41B 15/00, H03K 3/537

(54) **Mikrowellengenerator**
Microwave generator
Générateur de micro-ondes

(30) Priorität: 23.10.2001 DE 10151565
(43) Veröffentlichungstag der Anmeldung: 02.05.2003
(73) Patentinhaber: Diehl BGT Defence GmbH & Co.KG, 88662 Überlingen (DE)
(72) Erfinder: Staines, Geoffrey, Dr., 90552 Röthenbach (DE); Dommer, Josef, 90451 Nürnberg (DE); Sonnemann, Frank, 90403 Nürnberg (DE); Bohl, Jürgen, 90542 Eckenhaid (DE); Ehlen, Tilo, Dr., 90419 Nürnberg (DE)
(74) Vertreter: Diehl Patentabteilung

(56) Entgegenhaltungen:
- US-A- 3 748 528
- US-A- 3 761 720
- US-A- 4 104 558
- US-A- 4 875 022
- US-A- 4 905 673
- US-A- 5 142 194
- HONG K ET AL: "DEVELOPMENT OF ANTENNA-SOURCE SYSTEM FOR GENERATION OF HIGH-POWER ELECTROMAGNETIC PULSES" PPPS-2001. PULSED POWER PLASMA SCIENCE 2001.DIGEST OF TECHNICAL PAPERS. ( THE 28TH. IEEE INT. CONF. ON PLASMA SCIENCE: ICOPS/THE 13TH.IEEE INT. PULSED POWER CONFERENCE: PPC). LAS VEGAS, NV, JUNE 17 - 22, 2001, IEEE PULSED POWER PLASMA SCIENCE CONFERE, Bd. 1 OF 2, 17. Juni 2001 (2001-06-17), Seiten 203-206, XP001113855 ISBN: 0-7803-7120-8

## Beschreibung

Die Erfindung betrifft einen Mikrowellengenerator.

Ein solcher Mikrowellengenerator ist aus der US 4,104,558 A als abstimmbarer Pulsgenerator in der Bauform einer in einem metallenen Entladungsgehäuse isoliert gehalterten Funkenstrecke zwischen einem ringförmigen Elektrodenpaar bekannt, bei dem die eine Elektrode an der Stirnseite einer metallischen Haltestange ausgebildet ist, auf der vor ihrem gegenüberliegenden Ende eine Metallmanschette längsverschiebbar gehaltert ist. Deren Axialstellung auf der Haltestange bestimmt das Resonanzverhalten des Entladungsgehäuses, aus dem dann über eine hineinragende Koaxialleitung ein Impuls ausgekoppelt wird.

Bei einem dort so genannten Hochleistungs-Mikrowellenexpander ist gemäß der US 4,875,022 A vorgesehen, daß zwei Schraubbolzen koaxial aufeinander zu gerichtet die parallelen Wandungen eines Hohlleiters mit rechteckigem Querschnitt durchgreifen und dadurch eine längs einer Feldlinie verlaufende Funkenstrecke definieren, die elektrisch als Schaltstrecke im Abstand einer viertel Wellenlänge quer zum Hohlleiter wirkt. Die offene Funkenstrecke wirkt reflektierend auf den Energietransport durch den Hohlleiter; aber sie schaltet durch, wenn sie mit hinreichender Energie beaufschlagt wird, und führt dadurch zu einer Versteilerung der Flanken eines durch den Hohlleiter geführten Mikrowellenimpulses.

Aus der US 4,905,673 ist es zum Erzeugen von Stoßwellen zur berührungslosen Zerstörung von Konkrementen in Körpern von Lebewesen bekannt, eine Funkenstrecke mit Elektrodenspitzen unterschiedlicher Geometrie einzusetzen, die so aufeinander abgestimmt sind, daß infolge unterschiedlichen Abbrandes der Fokussierpunkt immer exakt in der Mitte zwischen den Spitzen der beiden Elektroden liegen bleibt. Die Funkenstrecke ist koaxial von einem isoliert ummantelten Stangenkäfig umgeben, an dem die eine Elektrode direkt leitend befestigt ist, während deren Gegenelektrode darin über einen Kunststoffdämpfer gehaltert ist.

Die vorliegende Erfindung betrifft dagegen einen abstimmbaren Mikrowellengenerator, dessen Funktion darauf beruht, daß eine Hochspannungsbatterie (etwa eine gemäß dem Prinzip der Marx'schen Stoßspannungsschaltung parallel aufgeladene und dann in Serie geschaltete Kondensatorbatterie) über eine Funkenstrecke entladen wird, die sich zwischen zwei Elektroden einstellt, über welche die Hochspannung momentan anliegt. Denn solch ein Entladungsvorgang führt zu einem steil einsetzenden und stark oszillierenden Stromfluß durch die Elektroden und somit auch in eventuell daran elektrisch leitend angeschlossenen Antennenleitem; und somit zu einer-entsprechend breitbandigen Abstrahlung eines Mikrowellenspektrums hoher Energiedichte, das in der Umgebung eines solchen Mikrowellengenerators den Funkverkehr zumindest beeinträchtigen und elektronische Schaltungen insbesondere eingangsseitig stören oder sogar zerstören kann.

Dieser Effekt einer intensiven Mikrowellenabstrahlung wird als nichtletale Waffe gegen gegnerische Kommunikationssysteme propagiert (vgl. DER SPIEGEL, Heft 7/1997, S. 53 ff, Ende des 3. Absatzes der linken Spalte von S. 54).

Der Erfindung liegt die Aufgabe zugrunde, einen derartigen Mikrowellengenerator anzugeben, der hinsichtlich seiner Energieversorgung autark, hinsichtlich seier Abmessungen unproblematisch verbringbar sowie vor allem hinsichtlich seines Störstrahlungsspektrums besonders universell und wirkungsvoll einsetzbar ist.

Diese Aufgabe ist durch die im Hauptanspruch angegebenen wesentlichen Merkmale der Erfindung gelöst.

Danach stehen unter radialer Distanz zur Innenwandung koaxial im Inneren eines rohrförmigen Gehäuses zwei Elektroden einander zur Definition einer Funkenstrecke axial distanziert gegenüber. Dieses Elektrodenpaar stellt eine Kapazität dar, in der Hochspannungsenergie gespeichert wird, bis es infolge Überschlags über die Funkenstrecke zur schlagartigen Energieentladung kommt. Zum Aufladen dieser Kapazität ist jede beider Elektroden an dem ihr zugewandten Stirnende des Gehäuses isoliert gehaltert und elektrisch an einen Hochspannungs-Generator angeschlossen. Bei dem handelt es sich bevorzugt um eine kleinbauende Marx'sche Stoßspannungsschaltung, deren Kondensatorbatterie statisch aus einer Gleichstromquelle oder dynamisch aus einem elektromechanischen Impulsgenerator in Parallelschaltung aufgeladen wird, ehe deren Umschaltung in Serie erfolgt, deren entsprechend vervielfachte Spannung an das Elektrodenpaar der genannten Funkenstrecke gelegt wird und zu deren Durchzünden führt.

Im Inneren des Gehäuses ist ferner, radial distanziert zu den Funkenelektroden parallel zu diesen, wenigstens ein hohlzylindrischer Leiter angeordnet, der sich vorzugsweise noch axial, über die Elektroden hinweg, über wenigstens einen Teil von deren Halterungen erstreckt. Dieser als abstimmbare Resonatorantenne dienende Leiter ist zur Resonanzverstimmung über den sehr breiten Bereich von wenigstens etwa einer Oktave an in ihrer Längserstreckung variablem Ort an eine der beiden Elektrodenhalterungen angeschlossen. Dadurch wirkt dieser Leiter als variabel frequenzbestimmendes und zugleich infolge Laufzeiteffekten wünschenswert impulsverlängerndes Glied für die durch die Hochspannungsentladung über die Funkenstrecke mit steiler Stromanstiegsflanke ausgelösten und deshalb kräftig abstrahlenden Stromoszillationen mit variablem Frequenzschwerpunkt. Das ermöglicht in der, der Pulslänge proportionalen, hohen abgestrahlten Störenergie ein gezieltes Anpassen des Mittenbereiches der wirksamen Wellenlängen etwa an die räumlichen Abmessungen der Leiterbahnen-Geometrie in der Eingangsbeschaltung jeweils eines bestimmten Types von Rechnern oder Kommunikationsgeräten, um dort infolge Resonanzüberhöhung der eingekoppelten Mikrowellenspannung Übersteuerungen oder gar Joul'sche Zerstörungen zu erzielen. Dieses erfindungsgemäße System ist demzufolge als frequenzmäßig optimierbarer hochenergetischer Impulsstörer um Größenordnungen wirksamer, als die herkömmliche Erzeugung von CW-Störenergie in Form gedämpfter Sinusschwingungen. Andererseits ist wegen der Breitbandigkeit des erfindungsgemäßen Störgenerators eine Anpassung einer Störfrequenz an die elektromechanischen Abmessungen des zu störenden Systems nicht einmal genau erforderlich.

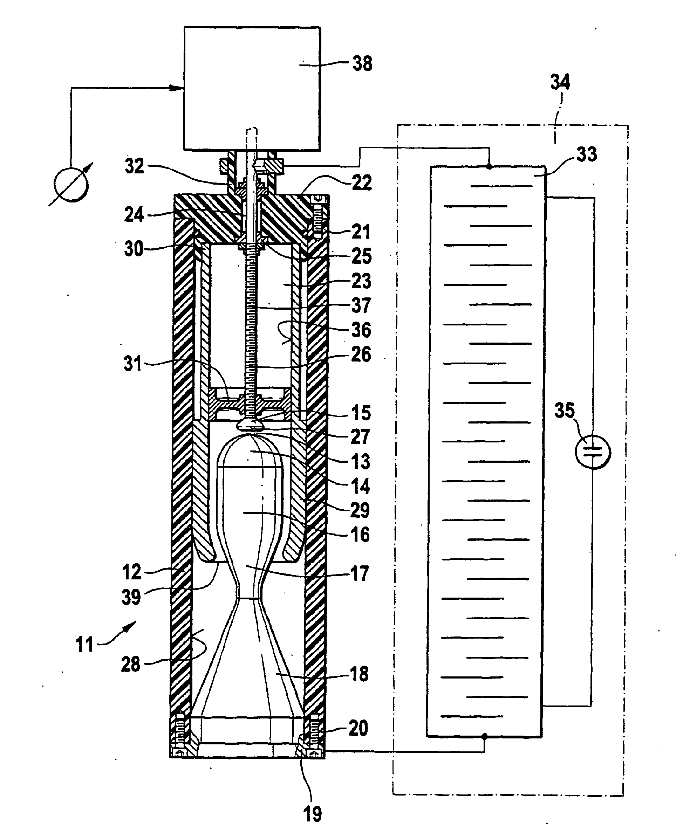

Zur näheren Erläuterung der Erfindung und der durch sie eröffneten Möglichkeiten sowie hinsichtlich weiterer Vorteile und Abwandlungen der vorstehend beschriebenen Lösung wird auf die weiteren Ansprüche verwiesen, sowie auf nachstehende Beschreibung der Zeichnung.

Die einzige Figur der Zeichnung zeigt im Axial-Längsschnitt unter Beschränkung auf das Funktionswesentliche stark abstrahiert, aber angenähert maßstabsgerecht skizziert, ein bevorzugtes Ausführungsbeispiel zur erfindungsgemäßen Lösung.

Der im Längsschnitt gezeigte Mikrowellengenerator 11 weist im Zentrum eines hohlzylindrischen Gehäuses 12 eine Funkenstrecke 13 zwischen einer kugelkappenförmigen Elektrode 14 relativ großen Durchmessers und einer koaxial ihr gegenüber axial versetzten, frontseitig pilzförmig abgerundeten und im übrigen flachzylindrischen Elektrode 15 dagegen wesentlich kleineren Durchmessers auf. Die erstgenannte Elektrode 14 stellt gewissermaßen den konvexen Boden einer im übrigen flaschenförmigen Halterung 16 dar, deren halsförmige Verjüngung 17 an die kleine Basis eines spitzwinkligen Kegelstumpfes 18 anschließt. Dieser trägt vor seiner koaxial in den Innenraum 23 des Gehäuses 12 eintauchenden großen Basis einen scheibenförmig umlaufenden Flansch 19, der axial vor dem benachbarten Stirnende 20 des Gehäuses 12 gehaltert ist.

In das gegenüberliegende Stirnende 21 des Gehäuses 12 ragt ein ebenfalls davor axial abgestützter Stopfen 22 hinein. Der weist in einem zentralen Durchgangsloch 24 eine Gleitlager-Buchse 25 für eine axial daran festgelegte Haltestange 26 auf, an deren gegenüberliegenden Stirnende 27 die kleinere Elektrode 15 koaxial befestigt ist.

Bei diesem Realisierungsbeispiel erstreckt sich zwischen der Verjüngung 17 der einen Elektroden-Halterung 16 und der gegenüberliegenden Elektroden-Halterung in Form des Stopfens 22 mit der Haltestange 26 wenigstens ein elektrischer Leiter 29, der auf der Innenwandung 28 des Gehäuses 12 isoliert gehaltert ist. Die Hohlzylinderwandung des Gehäuses 12 und der Stopfen 22 bestehen vorzugsweise aus elektrisch überschlagsresistentem Isoliermaterial, so daß der Leiter 29 nicht eigens selbst mit einer hochspannungsfesten Isolation auszustatten ist. Der Leiter 29 ist als metallener Hohlzylinder ausgelegt . Vorzugsweise ist dieser Leiter 29 nur in der Nachbarschaft der großen Elektroden-Halterung 16 an der Innenwand 28 des Gehäuses 12 kraftschlüssig festgelegt, während der restliche, längs der Haltestange 26 sich erstreckende Verlauf des Leiters 29 radial zur Gehäuse-Innenwand 28 distanziert und dann erst an seinem axialen Ende 30 im Stopfen 22 radial - und auch axial - gehaltert ist. Der Leiter 29 ist über eine radiale Brücke 31 an die Haltestange 26 und über diese deshalb an die kleine Elektrode 15 elektrisch angeschlossen.

Die Elektroden-Haltestange 26 ragt durch den Stopfen 22 hindurch in einen Anschlußstutzen 32 hinein, über den die kleine Elektrode 15 an einen Pol der Kondensatorbatterie 33 einer Marx'schen Stoßspannungsschaltung 34 anschließbar ist, deren gegenüberliegender Pol dann wie skizziert über den Flansch 19 mit der großen Elektrode 14 elektrisch leitend verbunden wird. In einer solchen Stoßspannungsschaltung 34 werden die in der Zeichnung nur symbolisch angedeuteten Kondensatoren der Batterie 33 aus einer kontinuierlich oder impulsartig arbeitenden Gleichspannungsquelle 35 in Parallelschaltung aufgeladen, um sie dann auf Serie umzuschalten und dadurch die Ausgangsspannung der Kondensatorbatterie 33 entsprechend zu vervielfachen. Diese Hochspannung liegt über den Elektroden 14-15 an, lädt also die zwischen ihnen bestehende Kapazität auf und zündet schließlich zwischen ihnen eine Funkenstrecke 13 durch, über welche diese Kapazität mit einem steilflankig einsetzenden Stromimpuls entladen wird. Dieser durch die Elektroden 14-15 fließende Entladestromimpuls führt kräftige Oszillationen aus, die auch in dem an diesen Entladestromkreis angeschlossenen Leiter 29 zu Stromoszillationen führen, deren Frequenzgemisch eine Resonänzüberhöhung nach Maßgabe der momentanen elektrisch wirksamen mechanischen Längenabmessungen des Leiters 29 erfährt, vergleichbar einer hochfrequenztechnischen Hohlraumresonator- oder Dipoldimensionierung.

Die von der Entladung der, bei mehr als 600 kV über die Elektroden 14-15 in typisch etwa 20 pF zwischengespeicherten, Hochspannungsenergie ausgelösten starken Stromoszillationen in der Größenordnung von etwa einem kA führen zur Abstrahlung eines entsprechend intensiven, infolge des abstimmbar an eine Elektrode 15 angeschlossenen einpoligen Leiters 29 mit reduzierten Amplituden breitbandiger oszillierenden und darin noch mit deutlicher Resonanzüberhöhung ausgestatteten elektromagnetischen Mikrowellenfeldes. Der Vorgang wiederholt sich je nach dem in erster Linie durch die Dimensionierung der Hochspannungsschaltung 34 vorgegebenen Ladezyklus der Kapazität über die Elektroden 14-15 und kann dadurch zu einer quasikontinuierlichen breitbandigen Störabstrahlung mit variabler Mittenfrequenz führen. Ein solcher Mikrowellengenerator ist kleinbauend realisierbar und kann deshalb insbesondere als einfach handhabbarer bzw. verbringbarer, sehr wirksamer Störer gegen die Funktion elektronischer Schaltungen vielseitig eingesetzt werden, da das Wirkspektrum auch im Betrieb noch über die Spindel 37 einfach durchwobbelbar bzw. direkt auf Resonanz mit der zu störenden Schaltungsgeometrie abstimmbar ist.

Der Frequenzbereich der Resonanzüberhöhung ist also dadurch in weiten Grenzen einfach veränderbar, daß die Brücke 31 zwischen der Elektroden-Haltestange 26 und dem Leiter 29 in Längsrichtung des Gehäuses 12 verschiebbar, insbesondere wie gezeigt als axial einstellbare Kurzschlußscheibe zwischen der Innenmantelfläche 36 eines hohlzylindrischen Leiters 29 und der Elektroden-Haltestange 26 ausgelegt ist. Für diese Axialverlagerung ist die im Interesse konstanter Länge der Funkenstrecke 13 axial fixiert gehalterte Elektroden-Haltestange 26 auf ihrer Oberfläche mit Spindelgängen 37 ausgestattet, und die Haltestange 26 selbst (samt ihrer Elektrode 15) ist im Stopfen 22 axial arretiert verdrehbar gehaltert. Die Abstimmung der Resonanzüberhöhung in der breitbandigen Mikrowellenabstrahlung erfolgt so durch Verkürzen oder Verlängern der elektrisch wirksamen Abmessung des an die eine Elektrode 15 angeschlossenen Leiters 29 mittels axialer Verlagerung der wie skizziert scheibenförmigen, gegen Mitdrehen arretiert geführten Kurzschlußbrücke 31 auf dem Spindelgang 37. Das Verdrehen des Spindelganges 37 zur Verlagerung der Brücke 31 kann hinter dem Anschlußstutzen 32 manuell erfolgen; oder, wie in der Zeichnung berücksichtigt, mittels eines dort angeflanschten, etwa batteriebetriebenen Stellmotors 38, dessen Rotor direkt oder über ein Getriebe mit dem der Elektrode 15 gegenüberliegenden Ende ihrer Haltestange 26 drehfest gekoppelt ist.

Der freie Stirnrand 39 des Leiters 29, insbesondere in seiner Ausbildung als Hohlzylinder, neigt sich vorzugsweise wie skizziert längs des Feldverlaufes der Halterungs-Verjüngung 17 zu. Eine stirnseitige Abrundung ergibt - wie an den freien Stirnflächen der Elektroden 14-15 - eine zusätzliche geometrische Anpassung der Metallflächen an den elektrischen Feldverlauf und vermeidet dadurch das Auftreten lokaler Feldüberhöhungen, die parasitäre Überschläge schon vor dem Zünden der Funkenstrecke 13 auslösen könnten.

Im Interesse einerseits eines erst bei hoher Spannung und mit entsprechend steiler Stromflanke einsetzenden Überschlags über die Funkenstrecke 13 und andererseits einer niedrigen Geschwindigkeit der Lichtbogenübertragung zwischen den Elektroden 14-15, was in wünschenswerter Weise zu einem mit vielen kleineren Amplituden verlängert schwingenden und deshalb mehr Energie abstrahlenden System führt, ist die Umgebung der Überschlagsstrecke, also der Innenraum 23 des Gehäuses 12, vorzugsweise mit einem elektrisch gut isolierenden Fluid möglichst hoher Dielektrizitätskonstante gefüllt, bei dem es sich einfach um destilliertes Wasser handeln kann. Das erlaubt wegen der Überspannungfestigkeit ein kleinbauendes Gehäuse 12 und das weist aufgrund seiner Wärmekapazität außerdem den Vorteil auf, bei Abklingen der Hochspannung den Überschlag über die Funkenstrecke 13 relativ abrupt wieder zu beenden und damit im Interesse abermals starker Oszillation auch eine steile Rückflanke des Entladestromes hervorzurufen.

So ergibt sich erfindungsgemäß ein kompaktbauender Mikrowellengenerator 11 mit leistungsstark breitbandiger Mikrowellenabstrahlung, in der eine deutliche Resonanzüberhöhung vorkommt, deren Frequenzschwerpunkt mechanisch veränderbar ist, um das Leistungszentrum hinsichtlich der abgestrahlten Wellenlängen der geometrischen Struktur eines zu störenden Schaltungsgebildes einfach anpassen zu können, indem ein die Funkenstrecke 13 zwischen den Elektroden 14-15 koaxial umgebender Leiter 29 mit variabler Länge als mechanisch einstellbarer Resonator an eine der beiden Elektroden (15) elektrisch angeschlossen ist.

## Patentansprüche

1. Mikrowellengenerator (11) mit Hochspannungs-Funkenstrecke (13) zwischen kolinear in einem hohlzylindrischen Gehäuse (12) angeordneten Elektroden (14, 15), wobei beiderseits der Funkenstrecke (13) die Elektroden (14, 15) und ihre koaxialen Halterungen (16, 26) zumindest über einen Teil ihrer axialen Längenausdehnung von einem distanziert dazu verlaufenden hohlzylindrischen elektrischen Leiter variabler Länge (29) begleitet sind, der die Elektroden (14, 15) und ihre Halterungen (16, 26) umgibt,
wobei eine im Gehäuse (12) radial sich erstreckende Brücke (31) zwischen dem Leiter (29) und einer der Elektroden-Halterungen (26) im Gehäuse (12) längsverschiebbar geführt ist,
wobei der hohlzylindrische Leiter (29) auch die Funkenstrecke (13) zwischen den Elektroden (14, 15) umgibt und als mechanisch einstellbarer Resonator an eine der beiden Elektroden (15) elektrisch angeschlossen ist,
wobei,
die radial sich im Gehäuse (12) erstreckende Brücke (31) als Kurzschluss-Scheibe verdrehungsgesichert auf einem Spindelgang (37) der haltestangenförmigen Halterung (26) geführt ist, die verdrehbar an einem Stirnende (21) des Gehäuses (12) axial fixiert gelagert ist.

2. Mikrowellengenerator nach dem vorangehenden Anspruch,
**dadurch gekennzeichnet,**
**dass** in der Längsachse des hohlzylindrischen Gehäuses (12) die zwei Elektroden (14,15) unterschiedlicher Durchmesser mit abgerundet aufeinander zu weisenden Stirnflächen in fester gegenseitiger axialer Position gehaltert sind.

3. Mikrowellengenerator nach einem der vorangehenden Ansprüche,
**dadurch gekennzeichnet,**
**dass** eine der Elektroden (14) der kugelkappenförmige Boden der einen, zylindrischen Halterung (16) ist, die axial gegenüberliegend eine flaschenhalsförmige Verjüngung (17) aufweist.

4. Mikrowellengenerator nach dem vorangehenden Anspruch,
**dadurch gekennzeichnet,**
**dass** die Halterungs-Verjüngung (17) an einen Kegelstumpf (18) angeschlossen ist, der mit einem umlaufenden Flansch (19) axial vor einem Stirnende (20) des hohlzylindrischen Gehäuses (12) gehaltert ist.

5. Mikrowellengenerator nach einem der beiden vorangehenden Ansprüche,
**dadurch gekennzeichnet,**
**dass** die andere Elektrode (15) an einem Ende der anderen, haltestangenförmigen Halterung (26) angeordnet ist, deren anderes Ende axial fixiert in einem Stirnende (21) des hohlzylindrischen Gehäuses (12) gehaltert ist.

6. Mikrowellengenerator nach einem der vorangehenden Ansprüche,
**dadurch gekennzeichnet,**
**dass** das Gehäuse (12) jedenfalls in der Umgebung des Leiters (29) aus einem elektrisch isolierenden Material besteht.

7. Mikrowellengenerator nach einem der Ansprüche 3 bis 6,
**dadurch gekennzeichnet,**
**dass** der Leiter (29) längs eines der zylindrischen Halterung (16) der einen Elektrode (14) benachbarten Bereiches an der Innenwand (28) des Gehäuses (12) gehaltert ist.

8. Mikrowellengenerator nach dem vorangehenden Anspruch,
**dadurch gekennzeichnet,**
**dass** der Leiter (29) längs eines der haltestangenförmigen Halterung (26) der anderen Elektrode (15) benachbarten Bereiches radial distanziert zur Innenwand (28) des Gehäuses (12) gehaltert ist.

9. Mikrowellengenerator nach einem der vorangehenden Ansprüche,
**dadurch gekennzeichnet,**
**dass** der Leiter (29) mit einem den Elektroden (15, 14) abgewandten Stirnende (30) axial und radial am Gehäuse (12) gehaltert (22) ist.

10. Mikrowellengenerator nach dem vorangehenden Anspruch,
**dadurch gekennzeichnet,**
**dass** die haltestangenförmige Halterung (26) mittels eines Stellmotors (38) verdrehbar ist.

11. Mikrowellengenerator nach einem der vorangehenden Ansprüche,
**dadurch gekennzeichnet,**
**dass** die Elektroden (14, 15) an eine Kondensatorbatterie (33) einer Stoßspannungsschaltung (34) angeschlossen sind.

## Claims

1. Microwave generator (11) having a high-voltage spark gap (13) between electrodes (14, 15) which are arranged in a colinear manner in a hollow-cylindrical housing (12), with, on both sides of the spark gap (13), the electrodes (14, 15) and their coaxial holders (16, 26) being accompanied at least over a portion of their axial longitudinal extent by a hollow-cylindrical electrical conductor (29) of variable length which runs at a distance from them and surrounds the electrodes (14, 15) and their holders (16, 26), with a bridge (31) which extends radially in the housing (12) being guided in a longitudinally displaceable manner in the housing (12) between the conductor (29) and one of the electrode holders (26), with the hollow-cylindrical conductor (29) also surrounding the spark gap (13) between the electrodes (14, 15) and being electrically connected to one of the two electrodes (15) as a mechanically adjustable resonator, with the bridge (31) which extends radially in the housing (12) being guided as a short-circuiting disc in a rotationally fixed manner on a spindle flight (37) of the holder (26) which is in the form of a holding rod and is mounted, such that it can rotate, in an axially fixed manner at an end (21) of the housing (12).

2. Microwave generator according to the preceding claim, **characterized in that** the two electrodes (14, 15) of differing diameter and with rounded end faces which face one another being held in a fixed mutual axial position in the longitudinal axis of the hollow-cylindrical housing (12).

3. Microwave generator according to either of the preceding claims, **characterized in that** one of the electrodes (14) is the spherical-cap-like base of one cylindrical holder (16) which has a bottleneck-like tapered portion (17) axially opposite.

4. Microwave generator according to the preceding claim, **characterized in that** the tapered portion (17) of the holder is connected to a truncated cone (18) which is held by a peripheral flange (19) axially in front of an end (20) of the hollow-cylindrical housing (12).

5. Microwave generator according to either of the two preceding claims, **characterized in that** the other electrode (15) is arranged at one end of the other holder (26) which is in the form of a holding rod, the other end of said holder which is in the form of a holding rod being held in an axially fixed manner in an end (21) of the hollow-cylindrical housing (12).

6. Microwave generator according to one of the preceding claims, **characterized in that** the housing (12) is composed of an electrically insulating material in the area surrounding the conductor (29) in any case.

7. Microwave generator according to one of Claims 3 to 6, **characterized in that** the conductor (29) is held on the inner wall (28) of the housing (12) along a region which is adjacent to the cylindrical holder (16) of one electrode (14).

8. Microwave generator according to the preceding claim, **characterized in that** the conductor (29) is held along a region which is adjacent to the holder (26), which is in the form of a holding rod, of the other electrode (15) at a radial distance from the inner wall (28) of the housing (12).

9. Microwave generator according to one of the preceding claims, **characterized in that** the conductor (29) is held (22) axially and radially on the housing (12) by way of an end (30) which is averted from the electrodes (15, 14).

10. Microwave generator according to the preceding claim, **characterized in that** the holder (26) which is in the form of a holding rod can be rotated by means of an actuating motor (38).

11. Microwave generator according to one of the preceding claims, **characterized in that** the electrodes (14, 15) are connected to a capacitor bank (33) of a surge-voltage circuit (34).

## Revendications

1. Générateur de micro-ondes (11) avec éclateur à haute tension (13) entre des électrodes (14, 15) disposées de manière colinéaire dans un boîtier cylindrique creux (12), dans lequel de part et d'autre de l'éclateur (13), les électrodes (14, 15) et leurs supports coaxiaux (16, 26) sont associés sur une partie au moins de leur extension longitudinale axiale à un conducteur (29) électrique cylindrique creux de longueur variable cheminant à une certaine distance, celui-ci entourant les électrodes (14, 15) et leurs supports (16, 26),
dans lequel un pont (31) s'étendant radialement dans le boîtier (12) entre le conducteur (29) et un des supports d'électrodes (26) est guidé de manière à pouvoir être déplacé longitudinalement dans le boîtier (12),
dans lequel le conducteur cylindrique creux (29) entoure également l'éclateur (13) entre les électrodes (14, 15) et est raccordé électriquement sous forme d'un résonateur réglable mécaniquement à une des deux électrodes (15),
dans lequel le pont (31) s'étendant radialement dans le boîtier (12) sous forme de disque de court-circuit est guidé en étant bloqué en rotation sur un arbre fileté (37) du support (26) en forme de barre de support, qui est fixé axialement de manière à pouvoir pivoter sur une extrémité frontale (21) du boîtier (12).

2. Générateur de micro-ondes selon la revendication précédente, **caractérisé en ce que** dans l'axe longitudinal du boîtier cylindrique creux (12), les deux électrodes (14, 15) de diamètres différents sont supportées dans une position axiale mutuelle fixe avec des surfaces frontales arrondies se faisant mutuellement face.

3. Générateur de micro-ondes selon une des revendications précédentes, **caractérisé en ce qu'**une des électrodes (14) constitue le fond en capuchon hémisphérique du support cylindrique (16) qui présente un amincissement (17) en goulot de bouteille à l'extrémité axialement opposée.

4. Générateur de micro-ondes selon la revendication précédente, **caractérisé en ce que** l'amincissement (17) du support se raccorde à un tronc de cône (18) supporté axialement par une bride périphérique (19) devant une extrémité frontale (20) du boîtier cylindrique creux (12).

5. Générateur de micro-ondes selon une des deux revendications précédentes, **caractérisé en ce que** l'autre électrode (15) est disposée à une extrémité de l'autre support (26) en forme de barre de support, dont l'autre extrémité est fixée axialement dans une extrémité frontale (21) du boîtier cylindrique creux (12).

6. Générateur de micro-ondes selon une des revendications précédentes, **caractérisé en ce que** le boîtier (12) dans l'environnement du conducteur (29) est composé en tout cas d'un matériau électriquement isolant.

7. Générateur de micro-ondes selon une des revendications 3 à 6, **caractérisé en ce que** le conducteur (29) est supporté sur la paroi interne (28) du boîtier (12), le long d'un des supports cylindriques (16) du domaine voisin d'une des électrodes (14).

8. Générateur de micro-ondes selon la revendication précédente, **caractérisé en ce que** le conducteur (29) est supporté à une certaine distance radiale de la paroi interne (28) du boîtier (12), le long d'un des supports (26) en forme de barre de support du domaine voisin de l'autre électrode (15).

9. Générateur de micro-ondes selon une des revendications précédentes, **caractérisé en ce que** le conducteur (29) est supporté sur le boîtier (12) axialement et radialement (22) par une extrémité frontale (30) détournée des électrodes (15, 14).

10. Générateur de micro-ondes selon la revendication précédente, **caractérisé en ce que** le support (26) en forme de barre de support peut être mis en rotation au moyen d'un moteur de réglage (38).

11. Générateur de micro-ondes selon une des revendications précédentes, **caractérisé en ce que** les électrodes (14, 15) sont raccordées à une batterie de condensateurs (33) d'un circuit de tension de choc (34).
